# EUROPEAN PATENT APPLICATION

(11) **EP 3 522 203 A1**
(43) Date of publication of application: **07.08.2019**
(21) Application number: 18154882.7
(22) Date of filing: 02.02.2018
(51) Int. Cl.: H01L 21/20

(54) **NANOELEMENT DEVICE WITH AT LEAST ONE NANOELEMENT FOR ELECTRICAL AND/OR OPTICAL COUPLING, AND METHOD OF MANUFACTURING THEREOF**

(71) Applicant: Forschungsverbund Berlin e.V., 12489 Berlin (DE)
(72) Inventor: Geelhaar, Lutz, 10785 Berlin (DE); Lewis, Ryan, Hamilton, ON L8L-7P2 (CA)
(74) Representative: v. Bezold & Partner Patentanwälte - PartG mbB

(57) **Abstract**

A nanoelement device 100 is disclosed, which comprises at least one nanoelement 10, like a nan-owire or nanowall, standing on a substrate 20 with a planar extension, wherein the at least one nanoelement 10 includes a core region 11 having at least one lateral side surface with a main extension along a longitudinal core shape from a foot section 12 to a head section 13 of the at least one nanoelement, and a bending region 14 being configured on the at least one side surface of the core region 11, such that strain is induced in the at least one nanoelement 10 and the at least one nanoelement 10 has a curved shape with a bending angle between the directions of the foot section 12 and the head section 13, and wherein the at least one nanoelement 10 has a predetermined bending direction being set by the configuration of the bending region 14 and being selected such that the at least one nanoelement 10 is bent towards a neighboring nanoelement 10 and/or a predetermined coupling section 25 of the substrate 20, and the at least one nanoelement 10 electrically and/or optically couples with the neighboring nanoelement 10 and/or the coupling section 25 of the substrate 20. Furthermore, methods of manufacturing the nanoelement device are disclosed.

## Description

The present invention relates to a nanoelement device, e. g. for electrical, optical or opto-electronic applications, in particular including at least one bent nanoelement on a substrate, and to a method of manufacturing the nanoelement device. Applications of the invention are available e. g. in the fields of optoelectronics, light emitters, light absorbers, optical components and electronic components.

Electrical and/or optical coupling of devices with characteristic dimensions in the µm and nm range pose challenges for design and fabrication technologies. These challenges arise due to difficulties in contacting small structures, difficulties in forming connections between dissimilar or three-dimensional (3D) device structures, and the need for scalability in the contacting technique. Common approaches for forming electrical/optical connections consist of bonding wires or optical fibers. While this approach provides a large amount of flexibility for contacting dissimilar structures, overcoming large contacting distances and for three-dimensional (3D) contacting geometries, it is not scalable and is strongly limited by the smallest structures which can be contacted. Another contacting approach is to use lithographic techniques. While conventional lithography is highly scalable and allows small structures to be contacted, it lacks design flexibility, being largely restricted to a two-dimensional (2D) geometry.

Nanowires are of interest for a wide range of device applications, including optical waveguides, electrical interconnects, optoelectronic devices such as light emitting diodes and detectors/sensors, and for integrating III-V optoelectronic devices with Si technology, and electrical interconnects. (see e. g. "Nature Photonics" 3, 569-576 (2009); or US 7 112 525 B1). Self-assembled nanowires have been synthesized at predetermined locations on pre-patterned substrates (see "J. Cryst. Growth" 272, 180-185 (2004)). Such self-assembled nanowires normally have a straight shape and extend either perpendicular to the substrate or in tilted directions. Connecting straight nanowires by growing on inclined substrates is described by S. Gazibegovic et al. in "Nature", vol. 548, 2017, p. 434. After growth, the connected nanowires are separated from the substrate and employed as a model system for quantum devices. Furthermore, straight nanowires bridging vertical grooves have been demonstrated (Nanotechnology 15 (2004) L5-L8).

Bent nanowires can be created by the effect of strain sharing in asymmetric lattice mismatched core-shell heterostructures (see e. g. Keplinger, M. et al. in "Nucl. Instruments Methods Phys. Res. Sect. B" 268, 316 (2010)). Up to now, only optical or optoelectronic applications of bent nanowires have been considered. For obtaining practical and efficient light emission applications of bent nanowires, placing active regions in a tensely strained portion of a nanowire has been suggested in European patent application No. 17157335.5 (not published at the priority date of the present specification).

The objective of the invention is to provide an improved nanoelement device with at least one nanoelement on a substrate, being capable of avoiding disadvantages or limitations of conventional nanoelement devices. In particular, the objective is to provide the nanoelement device with an extended range of applications, e. g. for electronic, optical or optoelectronic applications, and new and/or enhanced functions of the nanoelement. Furthermore, the objective of the invention is to provide an improved method of manufacturing the nanoelement device, being capable of avoiding disadvantages of conventional manufacturing methods.

These objectives are respectively solved by a nanoelement device and a method of manufacturing thereof, including the features of the independent claims. Preferred embodiments and applications of the invention are defined in the dependent claims.

According to a first general aspect of the invention, the above objective is solved by a nanoelement device, comprising a substrate with a planar extension and at least one nanoelement being arranged, in particular standing, on the substrate. The at least one nanoelement has a longitudinal extension deviating from the planar extension of the substrate. The at least one nanoelement has a core region with a main (averaged) extension along a longitudinal core shape of the nanoelement and including a foot section provided as a first nanoelement end fixed to (in particular synthesized, e. g. grown on) the substrate and a head section provided by a second, opposite nanoelement end. The core region has at least one longitudinally extending lateral side surface, which in dependency on the cross-sectional shape of the core region is e. g. a cylindrical surface or a facetted surface with multiple side facets. Furthermore, the at least one nanoelement has a bending region which is configured on the at least one side surface of the core region, preferably on at least one side of the at least one side surface, such that strain is induced in the at least one nanoelement. As a result of strain sharing between the core and bending regions, the at least one nanoelement is a bent nanoelement with a curved shape having a bending angle between the directions of the foot and head sections (directions of tangential extensions at the foot and head sections).

According to the invention, the at least one nanoelement has a predetermined bending direction, which is set by the configuration of the bending region and which is selected such that the at least one nanoelement is bent towards at least one other nanoelement on the substrate and/or a predetermined coupling section of the substrate. The other nanoelement comprises a further nanoelement standing on the substrate in a neighborhood of the considered bent nanoelement. Preferably, the other nanoelement is also a bent nanoelement, particularly preferred having equal properties like the considered bent nanoelement. Alternatively, coupling with a straight nanoelement is possible. The coupling section of the substrate generally is a surface region of the substrate, in particular a surface region of a plane substrate surface or a structured substrate surface or at least one substrate device arranged on the substrate. The coupling section comprises a material allowing a physical interaction with the bent nanoelement, in particular with the head section thereof.

Furthermore, according to the invention, the at least one nanoelement electrically and/or optically couples with the at least one other nanoelement and/or the coupling section of the substrate. Thus, the bent nanoelement also is called the nanocoupler. The coupling of the nanoelement with the neighboring nanoelement or with the coupling section comprises a mutual arrangement of the nanoelement(s) and/or coupling section such that a physical interaction is possible therebetween. The coupling comprises e. g. a mutual touching (mechanical and/or electrical contact) or a mutual approaching to a distance allowing an electromagnetic interaction, in particular a coupling of optical fields.

The term "nanoelement" refers to any solid structure having a longitudinal extension and a dimension (e. g. diameter, thickness) perpendicular to the longitudinal extension below 1 µm. Generally, the at least one nanoelement incudes at least two components, comprising the core region and the bending region carried by the core region on at least one side thereof. The strain and bending of the nanoelement is obtained by synthesizing the nanoelement in such a way that it induces strain in the nanoelement, e.g. by providing the core and bending region components having different lattice constants and/or different thermal expansion coefficients, or by changing the volume of the bending material or core (e.g. by oxidizing, reacting or implanting) after their initial formation. An example of fabricating the bent nanoelement by volume change is to deposit one material on at least one side of the at least one surface of the core (e.g. amorphous unstrained Al) and then subsequently react it (e.g. with O₂ to form Al₂O₃). In this case, the volume of the bending material increases and changes the crystal structure, resulting in the bending of the nanoelement. By the effect of lattice mismatch and/or thermal change and/or volume change after the growth process, the nanoelement is bent in a predetermined manner towards the at least one other nanoelement and/or the coupling section of the substrate.

The nanoelement can include further components, like at least one of another bending region on a different, e. g. an adjacent side relative to the first bending region, a shell region, an active region, a passivation region, a region with different electrical properties (e.g. doping) and a contact region. These further components can provide additional functions of the nanoelement, e. g. by forming a heterostructure of a light emitting element or a light absorbing element. As an example, the at least one nanoelement comprises an optoelectronic device configured for the emission or absorption of light, where the foot section and the section coupled with the neighboring nanoelement and/or the coupling section on the substrate form electrical contacts to the nanowire optoelectronic device. With a particular example, the at least one nanoelement comprises a nanowire light emitting diode which contains an axial heterostructure configured for light emission, so that advantages for contacting the light emitting diode by bending and easy connecting of the free end of the device to a contact layer are obtained.

The substrate has a solid substrate body with a substrate surface, which may be a plane surface of the substrate body or a structured surface of the substrate body or a surface including or carrying at least one contact layer and/or the at least one solid substrate device, like at least one electronic, optical and/or opto-electronic device. The planar extension of the substrate is represented by a reference plane parallel to the extension of the solid substrate body, e. g. the extension of the plane surface or the mean extension of the structured surface or the extension of the surface with the at least one substrate device. The substrate is made of e. g. a semiconductor, a metal, a ceramic or a plastic or polymer material.

The bending region is a deposit on the core region extending along the whole length or along a section of the length of the at least one nanoelement. The curved shape comprises a curvature along the whole length of the nanoelement or along a section thereof. In the latter case, the nanoelement includes a straight section and a curved (bent) section. As an example, the nanoelement could be initially grown with a straight shape and at an angle tilted from the substrate normal (e.g. a nanoelement section tilted by 45°), followed by a curved section (shaping by local bending region). As an alternative example, the nanoelement could be initially grown and bent with the bending region so that a curved section is obtained, followed by a straight section up to the head section. As a further alternative, the nanoelement can be inhomogeneously curved (e.g. with a higher curvature at the head) along the length or a section thereof. In all cases, the curvature is set such that the bent nanoelement approaches the other nanoelement and/or the coupling section of the substrate. To this end, a bending angle between the direction of the head section and a normal direction of the substrate preferably is at least 90°, in particular if the nanoelement is curved along the whole length thereof.

The inventors advantageously have found that by predefining the geometry of the bending region, in particular the deposition side on the core region, the material of the bending region and the extension of the bending region, a targeted bending of the nanoelement is provided. The nanoelement can be bent in a reproducible manner with a predetermined bending angle and orientation in space. Depositing the bending region acts like a mechanical bending towards a predetermined target. Bending by arranging the bending region can be obtained with high spatial precision in sub-µm range.

As a further particular advantage, the inventors have found that bending the nanoelement allows the provision of the mutual coupling of the nanoelement(s) and/or coupling section, thus providing new functions of the at least one nanoelement, in particular in the condition of standing on the substrate. New functions comprise e. g. guiding optical fields or electrical current between nanoelement(s) and/or substrate device(s).

Contrary to the special case of straight connecting nanowires inside groves as described by S. Gazibegovic et al., the invention provides much more generality and flexibility for a plurality of applications. The invention also offers an advantageous way to fabricate interconnects that bridge above elements/devices on the substrate that should not be contacted, as well as to contact dissimilar elements and form contacts with a 3D geometry. As a further advantage, the invention allows for bonding small structures (smaller than wire/fiber bonding) and can be scaled to contact a full wafer worth of such devices with a single process. These features go far beyond the prior art techniques and/or offer a simple alternative approach, which can be exploited to fabricate more complex devices.

According to a second aspect of the invention, the above objective is solved by a method of manufacturing the nanoelement device according to the above first aspect of the invention, wherein the core region is synthesized on the substrate in a first step and the bending region is deposited on at least one side of the at least one side surface of the core region in a second step, so that the predetermined curved shape of the at least one nanoelement and the coupling with another nanoelement and/or the coupling section of the substrate are obtained. The curved shape of the at least one nanoelement can be formed in a single deposition run by depositing the bending region from one side on at least one single side surface or on multiple side surfaces of the core region. Advantageously, this embodiment facilitates in particular the coupling of multiple nanoelement(s) and/or coupling section(s). Alternatively, the curved shape of the at least one nanoelement can be formed in a two steps deposition run, including depositing the bending region from one side on the at least one side surface of the core region and further depositing the bending region from a second side on the at least one side surface of the core region. This embodiment may have advantages in terms of providing complex coupling structures on a substrate. According to a further advantageous feature of the inventive method, the nanoelement can be bent in a first step and subsequently it can be thickened (e. g. by depositing additional bending material or by depositing some other material on top) to a final diameter in a second step. This embodiment has advantages if it is difficult to bend the nanoelement with the final diameter, which could be required e. g. for light guiding applications.

According to a preferred embodiment of the invention (in the following: first embodiment), the nanoelement device comprises a group of two or more nanoelements being arranged, in particular standing, on the substrate. The group of two or more nanoelements comprises a one-dimensional arrangement, e. g. a straight or even a curved row, or a two-dimensional arrangement, e. g. a matrix arrangement with straight or curved rows and columns, of bent nanoelements. Preferably, the nanoelements within the group have common bending properties, i. e. they have a common size and shape and orientation. Common bending properties means that all or nearly all nanoelements within the group have the same geometry (and single nanoelements may have a deviating geometry, e. g. due to an inhomogeneous deposition). The foot sections of the nanoelements are arranged with such a mutual distance, that the bent nanoelements can couple with each other. With the first embodiment, at least one nanoelement within the group is coupled with a neighboring nanoelement, particularly preferred with a directly neighboring nanoelement. The particular advantage of the first embodiment is given by the fact that a series or network of coupled nanoelements is provided, which can be used e. g. for distributing electrical and/or optical signals.

According to a preferred variant of the first embodiment, the head sections of the nanoelements (except of the last nanoelement in a line) are coupled with the neighboring nanoelements. Advantageously, this employs the whole lengths of the bent nanoelements for coupling, thus allowing to maximize the distance between the nanoelements. Alternatively, the bent nanowire can also extend beyond a neighboring one and touch on the side thereof. This variant of the first embodiment may have advantages in terms of ensuring a sufficient coupling between the nanoelements.

According to a further variant of the first embodiment, the nanoelements within the group (except the last two or more nanoelements in a line) are coupled with the neighboring nanoelement and further with at least one subsequent nanoelement. Multiple coupling locations allow for additional variations and complexity of the nanoelement network, as well as introducing redundancy in couplings.

According to a further preferred embodiment of the invention (in the following: second embodiment), the nanoelement device comprises one nanoelement coupling with a coupling section of the substrate or multiple nanoelements coupling with one or multiple coupling section(s) of the substrate. The second embodiment has advantages for guiding electrical and/or optical signals to the at least one coupling section. According to a first variant of the second embodiment, and for the case where the foot section of the nanoelements extends perpendicular to the substrate plane, the at least one nanoelement has a bending angle equal to about 180°. In this case, the foot section and the head section of the nanoelement are arranged in a common plane parallel to the planar extension of the substrate. The nanoelement has the shape of e. g. a semicircle. Alternatively, the bending angle of the nanoelements is below or above 180°, wherein the foot section is arranged in a first plane parallel to the planar extension of the substrate and the head section is arranged in a second, different plane parallel to the planar extension of the substrate. This variant has advantages if the substrate has a structured surface, e. g. with steps, or at least one substrate device, as it allows the connection of different surface sections with different heights above a surface of the substrate body. Furthermore, if the nanoelement is grown with a tilted geometry and/or an inhomogeneous curvature, the bending angle can be less than 180° for contacting the substrate.

The above first and second embodiments can be combined, so that both of at least one group of coupled nanoelements and at least one single nanoelement coupling with the substrate are included on the substrate. Advantageously, this allows the distribution of electrical and/or optical signals between different substrate devices, e. g. the guiding of optical fields from a surface emitter to multiple waveguides.

If, according to a further preferred modification of the invention, the substrate has a seed surface structure, the synthesis of one or a plurality of nanoelement(s) is facilitated and the anchoring of the nanoelements on the substrate is improved. Accordingly, the substrate preferably has at least one seed element accommodating the foot section of the at least one nanoelement. The seed element comprises e. g. a seed material supporting the local deposition of the nanoelement. The at least one seed element can be provided on the substrate surface, a layer thereon and/or a substrate device. Advantageously, the at least one seed element defines the position of the at least one nanoelement on the substrate relative to another nanoelement or substrate device.

For many optical or opto-electronic applications, the at least one nanoelement or a compartment thereof has a thickness and length being selected for guiding optical light and/or light signals. In other words, the nanoelement can be designed as a waveguide. Advantageously, this feature allows the guiding of optical fields between various substrate devices.

According to a further preferred embodiment of the invention, the substrate includes the substrate body and at least one substrate device, preferably being arranged on a surface of the substrate body. Preferred examples of substrate devices comprise an electronic circuit, a light emitter element (e. g. a vertical cavity surface emitting laser, a quantum emitter or a light emitting diode), a light absorber element (e. g. a photovoltaic element), an optical waveguide and/or an optical resonator, or parts thereof, like an electrical contact or a light coupler. Advantageously, techniques of manufacturing and/or integrating these types of devices on substrates are available.

As a further advantage, multiple variants of coupling the at least one nanoelement with the at least one substrate device are available. According to a first variant, the foot section of the at least one nanoelement is arranged in contact with the at least one substrate device. In other words, the at least one nanoelement is synthesized on the substrate device. Preferably, the at least one nanoelement and the substrate device are configured such that a coupling of the foot section with the substrate device is possible, e. g. by depositing an electrically conductive nanoelement on an electrically conductive coupling section of the substrate device or by growing an optical mode guiding nanoelement on a wave-guiding coupling section of the substrate device. With an alternative second variant, the coupling section of the substrate is included in a surface of the at least one substrate device, so that the head section of the nanoelement is coupled with the substrate device, while the foot section is coupled with the substrate surface or another substrate component thereon, like an electrically conducting or wave guiding layer. Furthermore, the nanoelement can connect two substrate devices with each other, which exist on the substrate (e.g. a light emitting and/or absorbing element and a waveguide).

Advantageously, a broad range of design options is available for providing the nanoelement device, the substrate and/or the at least one nanoelement thereof. Preferably, the substrate and/or the nanoelement comprise at least one semiconductor, metal, ceramic, plastic and/or polymer. With particularly preferred examples, the core and bending regions of the nanoelement can comprise two or more of these materials from the same material class, e. g. two semiconductors having different lattice constants and/or different thermal expansion coefficients or two metals having different thermal expansion coefficients. Alternatively, two of the above materials can be combined from the different material classes, e. g. by providing a semiconductor core region and a metal bending region or a ceramic core region and a semiconductor bending region. Depending on the application, the core region can comprise an electrically insulating, an electrically conductive or a semiconducting material. Different materials or material combinations can be combined on a common substrate.

Semiconductor materials, optionally including at least one dopant, are preferred due to their electrical and/or optical properties. Particularly preferred examples are nanoelements having a GaAs based core region and an (Al,Ga,In)As based bending region, or a GaN based core region and an (Al,Ga,In)N based bending region, or a Si based core region and a Si-Ge alloy based bending region. Metals, like e. g. a Ni core region with an Au bending region, may have advantages when the nanoelement device is employed for electrical coupling. Ceramics, like e. g. a SiO₂ based core region and a Si₃N₄ or Al₂O₃ based bending region can be preferred if the application of the nanoelement device requires an electrical insulation or particular chemical stability of the nanoelements. Such ceramic structures can be formed e. g. by subsequently oxidizing a Si/Si₃N₄ or Si/Al structure, respectively. Plastics and/or polymers would have advantages for applications in organic opto-electronic or sensor applications. For combining different material classes, e. g. a GaAs or Si core region with an Al or Pt bending region can be provided.

Further design options are available in terms of the shape of the at least one nanoelement. According to preferred embodiments of the invention, the at least one nanoelement comprises a nanowire (or nanocolumn). Preferably, the nanowire core has a thickness or diameter in a range from 2 nm to 500 nm and a length (length of unbent core region from foot to head sections) in a range from 100 nm to 100 µm. Nanowires have particular advantages in terms of bending flexibility and available manufacturing methods. Alternatively, the at least one nanoelement comprises a nanowall (or: fin). Preferably, the nanowall has a thickness in a range from 2 nm to 500 nm and a height (height of unbent wall core region from foot to head sections) in a range from 100 nm to 100 µm and a nanowall length in a range from 100 nm to 100 µm. Nanowalls have particular advantages in terms of enhancing nanoelement functions, e. g. emission or absorption in optical applications or guiding light through a free-space cavity created by bending the wall.

The targeted bending of the nanoelements can be set not only by selecting the materials of the at least one nanoelements, but also the geometrical features thereof. Preferably, an aspect ratio and/or a bending region/core region thickness ratio of the at least one nanoelement are preset geometrical features. Particularly preferred, the aspect ratio is selected in dependency on the materials (lattice mismatch and/or thermal expansion difference). Typically, the at least one nanoelement has an aspect ratio of at least 10 in case of bent nanowires with tilted geometry and at least 20 for bent nanowires vertically standing on the substrate. The bending region/core region thickness ratio of around 0.5 advantageously gives maximum bending, however other values could be used as well. Maximum bending may not be required, or it may be of interest to deposit beyond the maximum bending (as it could improve the contact ("welding"), or allow the total thickness of the structure to be increased after making the contact to support optical modes.

According to a further preferred embodiment of the invention, a cover material can be provided on the at least one nanoelement. The cover material is deposited such that it covers at least a portion of at least one side of the nanoelement. Advantageously, the touching of the nanoelements and/or coupling section can be improved by subsequently overgrowing a material (possibly the material of the bending region itself) to form an intimate contact. Furthermore, the cover material can be used to increase the diameter of the nanoelement such that it becomes suitable for the guiding of light.

Further details and advantages of the invention are described in the following with reference to the attached drawings, which show in:
- Figures 1 to 5:: schematic illustrations of nanoelement devices according to the first embodiment of the invention;
- Figures 6 and 7:: schematic illustrations of nanoelement devices according to the second embodiment of the invention;
- Figure 8:: a schematic top view on a nanoelement device having features according to preferred embodiments of the invention; and
- Figures 9 and 10:: microscopic images showing touching nanoelements.

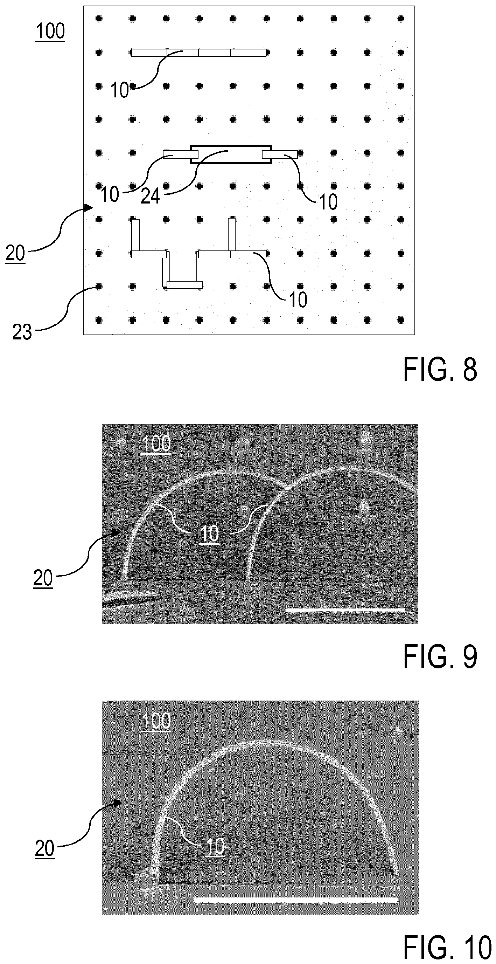

Embodiments of the invention are described in the following with reference to the arrangement of nanoelements of an inventive nanoelement device. The described features can be provided in a multiple nanoelement device or in a single nanoelement device. The implementation of the invention is not restricted to the described embodiments and examples. In particular, while most of the figures show linear arrangements of nanoelements only, other types of arrangements can be provided as mentioned above and e. g. shown in Figure 8. For the practical application, e. g. as a light emitter, an opto-electronic device or an electronic circuit, the nanoelement device is provided with further components, like electrical contacts on a substrate for injecting an excitation current into the nanoelement(s) or supplying electrical signals to an electronic circuit and optionally an encapsulation layer. The encapsulation layer, e. g. made of a conductive oxide, can be provided for embedding the nanoelement(s) and optionally carrying an electrical contact. The nanoelement device is manufactured e. g. by a directional deposition (e.g. by molecular beam epitaxy) of the nanoelements on the substrate, wherein the nanoelements are bent e. g. by the effect of lattice mismatch and/or different thermal expansion coefficients and/or volume change. The bent nanowires can have features as described in European patent application No. 17157335.5, which is introduced into the present specification by reference, in particular with regard to the design of bent nanowires and the arrangement of active regions thereof. The at least one nanoelement can be configured as a nanowire light emitting diode with an axial heterostructure as described in US 9 184 235 B2.

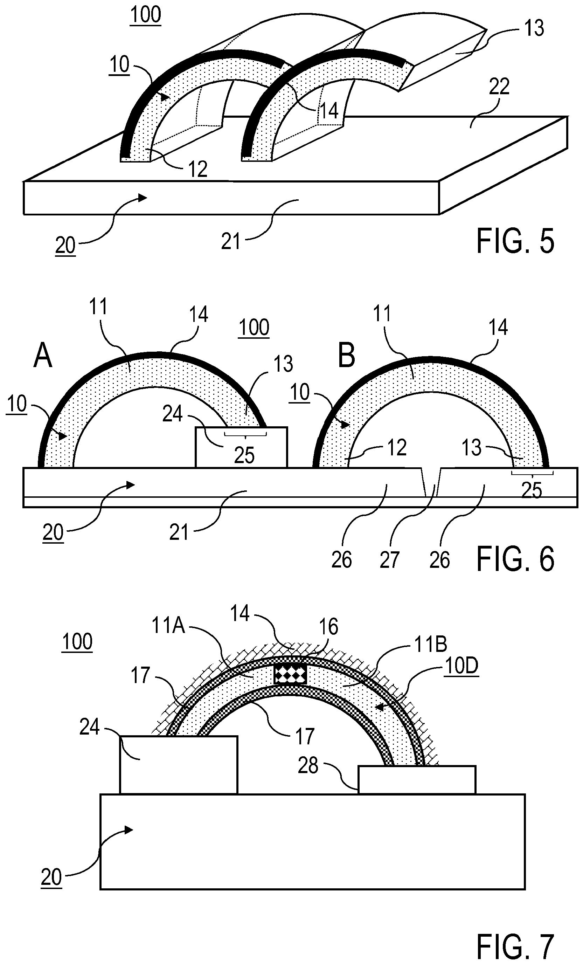

Exemplary reference is made to nanoelements comprising nanowires being made of semiconductor materials. The implementation of the invention is not restricted to nanowires with these materials, but alternatively possible with nanowalls (as shown in Figure 5) and/or other materials as mentioned above. Bent nanoelements are shown in most cases with a bending region on an upper curvature side (facing away from the substrate) of the nanoelements. Alternatively or additionally, bending regions can be arranged on a lower curvature side of the nanoelements or additionally on another side of the element to induce more complicated bent shapes. While the illustrations of the first embodiments show up to six coupled nanoelements only, larger numbers of nanoelements can be coupled in practical applications, e. g. up to 10,000 in a single chain.

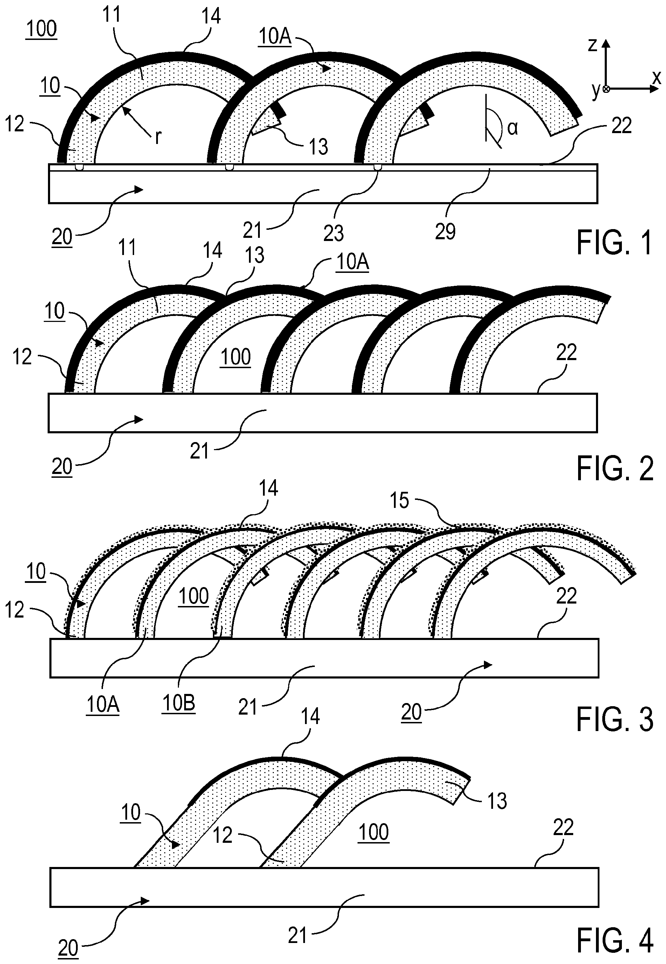

Figures 1 to 5 shows cross-sectional views of nanoelement devices 100 according to the first embodiment of the invention, composed of a group of bent nanoelements (e. g. 10, 10A, 10B) standing on a substrate 20. The x-y-plane (horizontal plane) is parallel to the planar extension of the substrate 20. Each nanoelement 10 has a core region 11 (diameter e. g. about 40 nm, material e. g. GaAs) grown on the substrate 20. The first end of the core region 11, where the nanoelement growth starts in the nanoelement deposition procedure, is the foot section 12, which stands on the substrate 20. The opposite end is the head section 13, which is a free end (Figures 1, 3) or coupled with the neighboring nanoelement 10A (Figure 2). The head section 13 is created at the end of the synthesis of the core region, and the bending region is subsequently created, which may slightly elongate the structure further. Furthermore, each nanoelement 10 has a bending region 14 (thickness e. g. about 20 nm, material e. g. Al_{0.5}In_{0.5}As), which is arranged on a side surface of the core region 11. The nanoelement 10 has e. g. a hexagonal cross section and the bending region 14 is deposited on at least one side facet of the hexagonal side surface of the nanoelement 10. However the invention is not restricted to the hexagonal case. As an alternative example, a cylindrical shape of the core region 10 can be provided. The nanoelement 10 length and bending radius r are e. g. about 4 µm and about 1.5 µm, respectively. If GaAs and Al_{0.5}In_{0.5}As are employed for the core and bending materials - corresponding to a lattice mismatch of 3.6% - then core aspect ratios of at least 45 and 90 are required to realize bending angles of 90 and 180 degrees, respectively. The minimum aspect ratio required to achieve a specific bending angle is inversely proportional to the lattice mismatch.

The substrate 20 comprises a substrate body 21, which is made of e. g. single crystal Si(111). The surface 22 of the substrate 20 is provided by the substrate body 21 itself or a layer on the substrate body 21, like a passivation layer, made of e. g. SiO₂ (with the holes in this layer defining seed elements). Preferably, the substrate 20 is a patterned substrate having seed elements 23 (shown in Figure 1 only, see also Figure 8). The seed elements 23 comprise local structures, like holes in a passivation layer 29 (as schematically shown in Figure 1) or locally restricted deposits of seed materials, like e. g. Au, which support the growth of the nanoelements 10, 10A.

According to a general feature of the invention, due to the known, preferably uniform, materials and geometric features of the core and bending regions 11, 14, the bending curvature of the nanoelements 10 can be determined, e. g. by numerical simulations or analytical strain calculations or experimental tests. If the core and bending regions form a coherent heterostructure with a lattice mismatch, the curvature of the nanoelement is linearly proportional to the lattice mismatch. Furthermore, due to the known positions of the foot sections 12 in the x-y-plane parallel to the substrate surface 22, the known bending curvature of the nanoelements and the uniform longitudinal lengths of the nanoelements (known from the manufacturing process), the course of the nanoelements 10 in space and the x-y-z positions of the head sections 13 are determined. According to the invention, the nanoelements (e. g. 10) are grown, and a bending radius r as well as a bending angle α between the substrate normal (z-direction) and the direction of the head section 13 are set such that the nanoelement (e. g. 10) approaches a neighboring nanoelement (e. g. 10A). The nanoelements touch each other, or they have a distance below a coupling distance allowing a coupling of electromagnetic fields therebetween, e. g. a distance below an optical wavelength.

According to Figure 1, the nanoelements 10 are arranged such that they touch each other along the length of the core region 11 with a distance from the foot and head sections 12, 13. Alternatively, as shown in Figure 2, the nanoelements 10 are arranged such that the head section 13 of a nanoelement (e. g. 10) touches the neighboring nanoelement (e. g. 10A) (see also Figures 4 and 10). Depending on the geometry of the nanoelements, in particular the length and locations on the substrate 20, the nanoelements even can touch two neighboring nanoelements (e. g. 10A, 10B) as shown in Figure 3.

Furthermore, Figure 3 schematically shows that the nanoelements 10 can be overgrown with a cover material 15. The cover material 15, which is deposited e. g. on top of the bending region 14 along the entire length of the nanoelements 10, can stabilize the coupling of the nanoelements 10. The cover material 15 comprises e. g. a metal or the bending material with a thickness of e. g. 100 nm. Alternatively, it may be used to increase the electrical conductivity of the element or to widen the element for the purpose of transmitting optical signals.

The bending region 14 can be extended along a portion of the longitudinal shape of the core region 11 only, as shown in Figure 4. In this case, the nanoelements have a lower straight portion and an upper curved portion. Again, the course of the nanoelements 10 and positions of the head sections 13 in space are determined, based on the materials, geometry and manufacturing conditions of the nanoelements, so that the bent nanoelements 10 standing on the substrate 20 touch each other.

Figure 5 schematically shows an implementation of the first embodiment of the invention, wherein the nanoelements 10 comprise bent nanowalls standing on the substrate 20 and being coupled with each other. In this case, the foot section 12 is given by the lower side of the nanowall, and the head section 13 couples with the neighboring nanowall. The length of the nanowall along the substrate is e. g. 2 µm. With an alternative variant of the invention, nanowires and nanowalls can be combined on a common substrate. In a further alternative variant, the nanowalls can be bent to contact a coupling section on the substrate. This presents additional design possibilities as the cavity created by the bent nanowall can be used to guide optical signals

Figures 6 and 7 show cross-sectional views of nanoelement devices 100 illustrating features of the second embodiment of the invention. The nanoelement device 100 comprises at least one nanoelement 10, which is bent towards the substrate surface 21. The nanoelement 10 including the core region 11 and the bending region 14 is created as mentioned above with materials and geometric dimensions allowing a coupling of the head section 13 by mechanically touching or by an electromagnetic interaction with a contact section 25 of the substrate 20.

As shown in Figure 6A, the substrate 20 can support a substrate device 24, which comprises e. g. a light emitting heterostructure. The bent nanowire 10 couples with an upper surface of the substrate device 24, e. g. a contact layer thereon, or alternatively with a lower surface (not shown). In the former case, with uniform bending, the bending angle is below 180°. With a tilted geometry and/or the inclusion of a straight segment and/or inhomogeneous bending, another bending angle can be provided. In this case, the nanoelement 10 is e. g. an electrically conducting line connecting the substrate device 24 via a contact layer on the substrate surface with a power supply or another electronic circuit (not shown). As alternatives to Figure 6A, both of the foot and head sections 12, 13 can stand on substrate devices, and the nanoelement 10 can be provided for electrically or optically coupling the substrate devices; or the foot section 12 can be grown on a substrate device, while the head section 13 couples with the substrate surface or a layer thereon (bending angle e. g. above 180°); or the substrate body 21 can have a recess, into which the head section of the nanoelement is bent (bending angle e. g. above 180°).

As another alternative, the nanoelement 10 can be bent with a bending angle of about 180°, as shown in Figure 6B, wherein both of the foot and head sections 12, 13 are coupled with the substrate surface 21 or a layer thereon. Figure 6B further schematically illustrates that the nanoelement 10 can be provided as an electrical or optical connection between two substrate regions 26 separated by a substrate feature such as a groove 27 or a substrate device (not shown).

The bent nanoelement according to the first and/or second embodiments can be configured as an optical component, e. g. as a light emitter or a light absorber, as schematically shown in Figure 7.

The nanoelement 10D has a core region 11 having a passivation region 17 (capping layers) on all sides thereof and the bending region 14 on an upper side, facing away from the substrate 20. The core region 11 provides a p-i-n heterostructure with a p core section 11A and an n core section 11B being separated by an active region 16. The p and n core sections 11A, 11B and the active region 16 are created e. g. by selective doping during synthesizing the nanoelement 10. Subsequently, the passivation region 17 is deposited, and the nanoelement 10 is bent by depositing the bending region 14. As a light emitter, the nanoelement 10D can stand on a surface device 24, providing e. g. a waveguide and/or an electrical contact, and on a surface layer 28, providing e. g. another electrical contact.

Figure 8 schematically shows a top view of a nanoelement device 100 illustrating examples of nanoelement arrangements. The substrate 10 is shown with a matrix pattern of seed elements 23 defining the locations of the nanoelements 10. Nanoelements of a nanoelement arrangement can be used to couple a substrate emitter and/or absorber to multiple other substrate devices, or to construct nano-circuits. The center portion of Figure 8 shows the coupling of a substrate device 24, like a waveguide or a light emitting diode, with nanoelements 10. According to the lower portion of Figure 8, the nanoelements 10 can be arranged as a network, e. g. having an electronic function. As an example, three nanoelements with a common coupling region can be combined. Fabricating a network, like in the lower portion of Figure 8, including nanoelements bent in different directions, is obtained with advanced processing. For example, additional elements (not shown) are provided to block the deposition on certain elements from certain directions (e.g. using a nanowall to shadow/prevent the deposition on a selected nanowire from a certain direction), so that it can be subsequently bent in a different direction.

Figures 9 and 10 show scanning electron microscope (SEM) images of bent nanoelements 10, which represent the base unit of the inventive nanoelement device 100. According to the SEM image of Figure 9, taken at a viewing angle of 20° from the substrate plane, two nanoelements 10 are coupled. According to Figure 10, a nanoelement 10 is bent completely over and contacts the substrate (20° viewing angle). The scale bars correspond to 2 µm in both figures.

With more details, the nanoelements 10 in Figure 9 comprise GaAs/Al_{0.5}In_{0.5}As core shell nanowires with respective core region diameter and bending region (shell) thickness of 45 and 20 nm, selectively grown on a pre-patterned Si(111) substrate 20. The bent nanowires, which were straight and standing vertically before bending region deposition, are bent by more than 90° away from the substrate normal. These nanowires have a bending radius r of about 1.5 µm and are bent away from the direction from which the group III fluxes impinged during bending region deposition. The bending is a result of strain sharing between the GaAs core and the asymmetric Al_{0.5}In_{0.5}As bending region, which has a lattice mismatch of 3.6% from GaAs. Analytical strain calculations for the coherently strained structure result in a similar bending radius of 1.3 µm. Generally, the minimum bending radius rₘᵢₙ is achieved for a bending region/core region thickness ratio of around 0.5, and rₘᵢₙ increases linearly with increasing d_{core}. While Figure 9 illustrates a pair of connected nanowires, multiple nanowires can also be connected in chains.

The micrographs of Figures 9 and 10 demonstrate that bending nanowires by more than 90° in controlled directions allows the provision of coupled nanowires. The invention has the advantage of a great design freedom, as the bending direction is determined simply by the side of the nanowires that the bending region is deposited on. Figure 10 shows the nanowire with a thinner 30-nm-diameter core region, bent completely over to contact the substrate (bending radius about 1.1 µm).

For the bending of nanowires by 90° and 180°, nanowires with lengths of at least π/2*rₘᵢₙ and π*rₘᵢₙ, respectively, are preferably formed. As rₘᵢₙ is limited by the nanowire core region thickness, the aspect ratio of the core limits how much a nanowire can be bent.

The features of the invention disclosed in the above description, the drawings and the claims can be of significance individually, in combination or sub-combination for the implementation of the invention in its different embodiments.

## Claims

1. Nanoelement device (100), comprising at least one nanoelement (10) standing on a substrate (20) having a planar extension, wherein the at least one nanoelement (10) includes
- a core region (11) having at least one lateral side surface with a main extension along a longitudinal core shape from a foot section (12) to a head section (13) of the at least one nanoelement, and
- a bending region (14) being configured on the at least one side surface of the core region (11), such that strain is induced in the at least one nanoelement (10) and the at least one nanoelement (10) has a curved shape with a bending angle between the directions of the foot section (12) and the head section (13),
**characterized in that**
- the at least one nanoelement (10) has a predetermined bending direction being set by the configuration of the bending region (14) and being selected such that the at least one nanoelement (10) is bent towards a neighboring nanoelement (10) and/or a predetermined coupling section (25) of the substrate (20), and
- the at least one nanoelement (10) electrically and/or optically couples with the neighboring nanoelement (10) and/or the coupling section (25) of the substrate (20).

2. Nanoelement device according to claim 1, wherein
- a group of two or more nanoelements (10) is arranged on the substrate (20), and
- at least one nanoelement (10) within the group being directed to a neighboring nanoelement (10) within the group is coupled with the neighboring nanoelement (10A).

3. Nanoelement device according to claim 2, wherein
- the at least one nanoelement (10) within the group is coupled with the neighboring nanoelement (10) and further with a subsequent nanoelement (10B).

4. Nanoelement device according to one of the foregoing claims, wherein
- the at least one nanoelement (10) couples with the coupling section (25) of the substrate (20) with the foot section (12) and the head section (13) being arranged in a common plane parallel to the planar extension of the substrate (20).

5. Nanoelement device according to one of the claims 1 to 3, wherein
- the at least one nanoelement (10) couples with the coupling section (25) of the substrate (20) with the foot section (12) being arranged in a first plane parallel to the planar extension of the substrate (20) and the head section (13) being arranged in a second, different plane parallel to the planar extension of the substrate (20).

6. Nanoelement device according to one of the foregoing claims, wherein
- the substrate (20) has at least one seed element (23) accommodating the foot section (12) of the at least one nanoelement (10).

7. Nanoelement device according to one of the foregoing claims, wherein
- the at least one nanoelement (10) has a thickness and length being selected such that the at least one nanoelement (10) is capable of guiding optical light.

8. Nanoelement device according to one of the foregoing claims, wherein
- the substrate (20) includes at least one substrate device (24), comprising at least one of an electronic circuit, a light emitter element, a light detector element, an optical waveguide and an optical resonator, or a part thereof.

9. Nanoelement device according to claim 8, including at least one of the following features
- the foot section (12) of the at least one nanoelement (10) is coupled with the at least one substrate device (24),
- the head section (13) of the at least one nanoelement (10) is coupled with the at least one substrate device (24),
- the foot section (12) and the head section (13) are coupled with different parts of one substrate device (24) or with different substrate devices, and
- the coupling section (25) of the substrate (20) is included in a surface of the at least one substrate device (24).

10. Nanoelement device according to one of the foregoing claims, including at least one of the features
- the at least one nanoelement (10) comprises at least one of at least one semiconductor, at least one metal, at least one ceramic, at least one plastic and at least one polymer,
- the core region (11) comprises an electrically insulating, an electrically conductive or a semiconducting material,
- the core region (11) comprises GaAs and the bending region (14) is made of (Al,Ga,In)As,
- the core region (11) comprises GaN and the bending region (14) is made of (Al,Ga,In)N,
- the core region (11) comprises Si and the bending region (14) is made of a Si-Ge alloy,
- the core region (11) comprises SiO₂ and the bending region (14) is made of Si₃N₄ or Al₂O₃, and
- the core region (11) and the bending region (14) comprise materials with different lattice constants and/or different thermal expansion coefficients and/or different volume changes after their initial formation.

11. Nanoelement device according to one of the foregoing claims, wherein
- the at least one nanoelement (10) comprises a nanowire or a nanowall (fin).

12. Nanoelement device according to one of the foregoing claims, wherein
- the core region of the at least one nanoelement (10) has an aspect ratio of at least 10.

13. Nanoelement device according to one of the foregoing claims, wherein
- the at least one nanoelement (10) comprises a nanoelement optoelectronic device (10D) configured for the emission and/or absorption of light, wherein the foot section and/or the section coupled with the neighboring nanoelement (10) and/or the coupling section (25) on the substrate form electrical contacts and/or an optical coupling to the nanoelement optoelectronic device.

14. Nanoelement device according to one of the foregoing claims, further including
- a cover material (15) covering either a portion of or the entire nanoelement where the at least one nanoelement (10) couples with the neighboring nanoelement (10) and/or the coupling section (25) of the substrate (20).

15. Method of manufacturing the nanoelement device according to one of the foregoing claims, comprising the steps of
- creating the core region (11) of the at least one nanoelement (10) on the substrate (20), and
- depositing the bending region (14) on the at least one side surface of the core region (11), so that the curved shape of the at least one nanoelement (10) and the coupling with a neighboring nanoelement (10) and/or the coupling section (25) of the substrate (20) are obtained.

16. Method according to claim 15, wherein
- the curved shape of the at least one nanoelement (10) is formed in a single deposition run by depositing the bending region (14) from one side on one single side surface or on multiple side surfaces of the core region (11).

17. Method according to claim 15, wherein
- the curved shape of the at least one nanoelement (10) is formed in a two steps deposition run, including depositing the bending region (14) along a first direction on the at least one side surface of the core region (11) to induce bending in the first direction and further depositing the bending region (14) along a different, second direction on the at least one side surface of the core region (11) to induce bending in the second direction.
